# EUROPÄISCHE PATENTSCHRIFT

(11) **EP 0 362 512 B1**
(45) Veröffentlichungstag und Bekanntmachung des Hinweises auf die Patenterteilung: **19.05.1993**
(21) Anmeldenummer: 89114377.8
(22) Anmeldetag: 03.08.1989
(51) Int. Cl.: C25D 17/00, C25D 17/28

(54) **Galvanisiereinrichtung für plattenförmige Werkstücke, insbesondere Leiterplatten**
Electroplating apparatus for planar work pieces, particularly circuit boards
Appareil pour le revêtement électrolytique de pièces en forme de plaque, notamment de cartes de circuits imprimés

(30) Priorität: 01.09.1988 DE 3829761
(43) Veröffentlichungstag der Anmeldung: 11.04.1990
(73) Patentinhaber: Siemens Nixdorf Informationssysteme Aktiengesellschaft, 33102 Paderborn (DE)
(72) Erfinder: Hosten, Daniel, B-Handzame (Kortemark) (BE)
(74) Vertreter: Fuchs, Franz-Josef, Dr.-Ing.

(56) Entgegenhaltungen:
- EP-A- 0 254 030
- EP-A- 0 254 962
- EP-A- 0 361 029
- GB-A- 1 482 958
- GB-A- 2 149 820

## Beschreibung

Die Erfindung betrifft eine Galvanisiereinrichtung für im horizontalen Durchlauf zu behandelnde plattenförmige Werkstükke, insbesondere Leiterplatten, mit
- einer Transporteinrichtung für den Transport der Werkstücke durch eine Elektrolytlösung,
- mindestens einer seitlich der Durchlaufbahn angeordneten Kontaktiervorrichtung mit endlos umlaufenden Kontaktmitteln zur kathodischen Kontaktierung der Werkstücke,
- einer seitlich der Durchlaufbahn angeordneten Abdeckung zum Schutz der Kontaktmittel der Kontaktiervorrichtung vor dem Zutritt von Elektrolytlösung und mit
- mindestens einer im Bereich der rücklaufenden Kontaktmittel angeordneten Reinigungs-Einrichtung zur Reinigung der umlaufenden Kontaktmittel.

Eine derartige Galvanisiereinrichtung ist aus der EP-A-0 254 962 bekannt. Bei der dort beschriebenen Galvanisiereinrichtung ist die Kontaktiervorrichtung zur kathodischen Kontaktierung der Werkstücke durch seitlich mit dem jeweiligen Werkstück verfahrbare zangenförmige Kontaktklemmen gebildet, wobei vorzugsweise eine endloser Trieb als verfahrbarer Träger der Kontaktklemmen dient. Dabei sind zu Beginn und Ende des Transportweges der plattenförmigen Werkstücke Mittel vorgesehen, die ein Ergreifen des Seitenrandes der Werkstücke durch die Kontaktklemmen, bzw. das Freigeben der Werkstücke durch die Kontaktklemmen bewirken. Die Kontaktklemmen können dabei auch gleichzeitig als Transportorgane für den Durchlauf der Werkstücke dienen. Durch eine seitlich sich in Durchlaufrichtung erstreckende und am jeweiligen Werkstück federnd anliegende Dichtung werden die Kontaktklemmen vor dem Zutritt von Elektrolytlösung abgeschirmt. Im Bereich der rücklaufenden Kontaktklemmen ist mindestens eine Reinigungs-Einrichtung angeordnet, mit welcher eventuell auf den Kontaktflächen der Kontaktklemmen abgeschiedenes Metall entfernt wird.

Aus der DE-A-36 24 481 ist eine weitere Galvanisiereinrichtung bekannt, bei welcher die Transporteinrichtung als eine endlos umlaufende, angetriebene Reihe einzelner Transportorgane ausgebildet ist, welche die Seitenränder der plattenförmigen Werkstücke festhalten und in der Transportrichtung bewegen, wobei zu Beginn und Ende des in der Elektrolysekammer gelegenen Transportweges der plattenförmigen Werkstücke Mittel vorgesehen sind, die ein Erfassen der plattenförmigen Werkstücke durch die Transportorgane, bzw. das Freigeben der plattenförmigen Werkstücke durch die Transportorgane bewirken. Dabei ist - abgesehen vom Beginn des Ergreifens bzw. Beginn des Freigebens - keine Relativbewegung zwischen den Transportorganen und den Werkstücksrändern gegeben, so daß Abnützungserscheinungen bzw. Abriebserscheinungen der Transportorgane vermieden werden. Die Transportorgane können dann auch zugleich der Stromzuführung zu den plattenförmigen Werkstücken dienen.

Der Erfindung liegt die Aufgabe zugrunde die Kontaktiervorrichtung einer gattungsgemäßen Galvanisiereinrichtung so auszugestalten, daß mit geringem Aufwand eine sichere kathodische Kontaktierung der Werkstücke gewährleistet ist.

Zur Lösung dieser Aufgabe ist vorgesehen, daß zur Erfassung des über die Abdeckung überstehenden Seitenrandes der Werkstücke endlos umlaufende mit dem Werkstück mitlaufende Kontaktbürsten oder Kontaktfedern als Kontaktmittel vorgesehen sind.

Die mit dem Werkstück mitlaufenden Kontaktbürsten oder Kontaktfedern haben insbesondere den Vorteil, daß sie zu Beginn und Ende des Transportweges keine Betätigungseinrichtungen benötigen und daß sie beim Rücklauf problemlos einer Reinigung unterzogen werden können. Durch diese Reinigung der Kontaktmittel kann die kathodische Kontaktierung der Werkstücke entscheidend verbessert werden.

Laufen die Kontaktbürsten oder Kontaktfedern synchron mit dem Werkstück mit, so ist keine Relativbewegung zwischen den Kontaktmitteln und den Werkstücksrändern gegeben, d.h. Abnützungserscheinungen bzw. Abriebserscheinungen der Kontaktmittel werden vermieden.

Gemäß einer bevorzugten Ausgestaltung der Erfindung sind Kontaktbürsten in Form eines endlos umlaufenden Bürstenbandes vorgesehen, welches im Kontaktierungsbereich auf einer rückseitig angeordneten Stromschiene gleitet.

Eine sehr zuverlässige kathodische Kontaktierung der Werkstücke kann auch dadurch erreicht werden, daß auf einem endlos umlaufenden Metallband paarweise einander gegenüberliegende Kontaktfedern befestigt sind, die federnd an der Oberseite und der Unterseite der Werkstücke anliegen. Eine weitere bevorzugte Ausgestaltung der Erfindung ist gekennzeichnet durch eine als elektrolytische Entmetallisierungszelle ausgebildete Reinigungs-Einrichtung. Hierdurch wird eine besonders zuverlässige elektrochemische Entkupferung der Kontaktmittel beim Rücklauf erzielt.

Ausführungsbeispiele der Erfindung sind in der Zeichnung dargestellt und werden im folgenden näher beschrieben.

Es zeigen
- Fig. 1: eine perspektivische teilweise aufgebrochene Darstellung einer Galvanisiereinrichtung mit einem endlos umlaufenden Bürstenband zur kathodischen Kontaktierung von in horizontaler Lage durchgeführten Leiterplatten und
- Fig. 2: eine zweite Ausführungsform gemäß welcher die mit dem Werkstück mitlaufenden Kontaktmittel aus einem Metallband und daran angebrachten Kontaktfederpaaren bestehen.

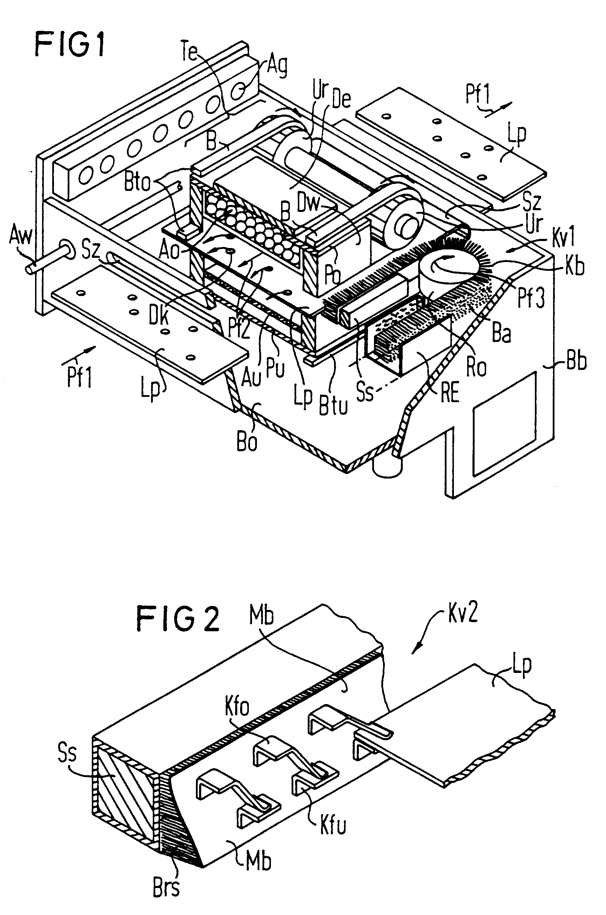

Fig. 1 zeigt in perspektivischer Darstellung die Galvanisiereinrichtung einer Horizontal-Durchlaufanlage zum Durchkontaktieren und Galvanisieren von Leiterplatten Lp. Es ist zu erkennen, daß die beiden Stirnwände eines Badbehälters Bb in Höhe einer durch Pfeile Pf1 aufgezeigten horizontalen Durchlaufbahn mit horizontalen Schlitzen Sz versehen sind, die den Durchtritt der Leiterplatten Lp ermöglichen. Der Innenraum zwischen einer in Fig. 1 nicht näher dargestellten oberen Abschlußhaube und dem eine Elektrolytlösung aufnehmenden Badbehälter Bb ist auf einer Seite mit einer Absaugung Ag versehen, die zur Erzeugung eines Unterdrucks in diesem Raum an eine zentrale Absaugeinrichtung angeschlossen ist. Unterhalb der Absaugung Ag ist eine in Längsrichtung verlaufende Antriebswelle Aw zu erkennen, welche die beiden in Fig. 1 dargestellten oberen Umlenkrollen Ur über nicht näher dargestellte Kegelräder antreiben. Jede dieser beiden dargestellten oberen Umlenkrollen Ur gehört zu einer seitlich angeordneten Transporteinrichtung Te, welche die Leiterplatten Lp in Richtung der Pfeile Pf1 durch die Elektrolytlösung transportiert. Jede dieser beidseitig der Durchlaufbahn Pf1 angeordneten Transporteinrichtungen Te besteht aus einem oberen Bandtrieb Bto und einem unteren Bandtrieb Btu, wobei die beiden Bandtriebe jeweils ein über zwei im Abstand zueinander angeordnete Umlenkrollen Ur endlos umlaufendes Band B aufweisen. Über die Antriebswelle Aw sind die genannten Bandtriebe jeweils derart angetrieben, daß die durch den in Durchlaufrichtung Pf1 vorderen Schlitz Sz eintretenden Leiterplatten Lp jeweils zwischen die Bandtriebe Bto und Btu eingezogen und zwischen dem horizontalen unteren Trum des oberen Bandtriebes Bto und dem horizontalen oberen Trum des unteren Bandtriebes Btu in Richtung des Pfeiles Pf1 reibschlüssig mitgenommen werden. Die Bänder B liegen dabei im Seitenbereich der Leiterplatte Lp über die gesamte Länge dicht an der Oberseite und der Unterseite an, so daß zwischen Band B und Leiterplatte Lp keine Elektrolytlösung hindurchtreten kann. Zwischen den beiden oberen Trumen der oberen Bandtriebe Bto ist eine sich quer zur Durchlaufrichtung Pf1 erstreckende obere Platte Po angeordnet, an deren Oberseite die oberen Trume dicht anliegen. Zwischen der Unterseite der oberen Platte Po und den unteren Trumen der oberen Bandtriebe Bto erstrecken sich jeweils Dichtwände Dw. In ähnlicher Weise liegen die unteren Trume der unteren Bandtriebe Btu mit ihrer Unterseite dicht auf dem Boden Bo des Badbehälters Bb und mit ihrer Oberseite dicht auf einer sich quer zur Durchlaufrichtung Pf1 erstreckenden unteren Platte Pu an. Auch hier sind dann zwischen der unteren Platte Pu und den oberen Trumen der unteren Bandtriebe Btu Dichtwände Dw angeordnet. Somit ist ohne weiteres zu erkennen, daß die oberen Bandtriebe Bto und die unteren Bandtriebe Btu in Verbindung mit der oberen Platte Po bzw. der unteren Platte Pu und den Dichtwänden Dw eine Abschirmung bzw. Abdeckung bilden, welche den seitlichen Austritt von Elektrolytlösung zumindest weitgehend verhindert.

Fig. 1 zeigt ferner, daß sich zwischen den Dichtwänden Dw in geringem Abstand oberhalb der Durchlaufbahn Pf1 der Leiterplatten Lp eine horizontal ausgerichtete obere Anode Ao befindet, die aus einem Korb aus Streckmetall und darin enthaltenem kugelförmigen Anodenmaterial besteht. Um das Anodenmaterial austauschen zu können, ist die obere Platte Po mit einer durch einen Deckel De verschließbaren Öffnung versehen. In geringem Abstand unterhalb der Leiterplatten Lp ist eine ebenfalls horizontal ausgerichtete untere Anode Au angeordnet, die als Streckmetallsieb ausgebildet ist und beispielsweise aus platiniertem Titan besteht. Im Gegensatz zur oberen Anode Ao, die beispielsweise Kupferkugeln als Anodenmaterial enthält, handelt es sich bei der unteren Anode Au also um eine unlösliche Anode.

Die in Fig. 1 nicht dargestellte seitliche Zufuhr von Elektrolytlösung in den abgedichteten Bereich des Badbehälters Bb und der Ablauf über einen in den Boden Bo eingebrachten Ablaufstutzen As sind so bemessen, daß durch die Durchkontaktierungslöcher Dk der Leiterplatten Lp eine nach oben gerichtete und durch Pfeile Pf2 aufgezeigte Strömung entsteht. Durch diese Strömung wird - sofern andere Voraussetzungen erfüllt sind - eine qualitativ hochwertige galvanische Verstärkung der Durchkontaktierungen gewährleistet.

Die kathodische Kontaktierung der Leiterplatten Lp erfolgt über eine in Durchlaufrichtung Pf1 rechts angeordnete Kontaktiervorrichtung Kv1, deren Kontaktmittel die über die Transporteinrichtung Te überstehenden Seitenränder der Leiterplatten Lp erfassen. Auf der linken Seite der Durchlaufbahn Pf1 wird zweckmäßigerweise eine in Fig. 1 nicht erkennbare zweite Kontaktiervorrichtung Kv1 angeordnet. Die Kontaktiervorrichtung Kv1 umfaßt Kontaktbürsten Kb in Form eines über zwei Rollen Ro endlos umlaufenden Bürstenbandes. Die in Fig. 1 erkennbare hintere Rolle Ro ist dabei in Richtung des Pfeiles Pf3 derart angetrieben, daß das Bürstenband mit den Kontaktbürsten Kb synchron mit den Leiterplatten Lp mitläuft. Die Zufuhr des Kathodenstroms erfolgt über eine ortsfest angeordnete Stromschiene Ss auf das darauf gleitende Bürstenband und von dessen Kontaktbürsten Kb auf die Oberseite und die Unterseite der jeweiligen Leiterplatte Lp.

Sollten sich auf den Kontaktbürsten Kb durch eventuell austretende Elektrolytlösung unerwünschte Metallabscheidung und Ablagerungen bilden, so werden diese im Bereich des rücklaufenden Trums des Bürstenbandes durch eine Reinigungs-Einrichtung RE wieder entfernt. Diese Reinigungs-Einrichtung RE ist als elektrolytische Entmetallisierungszelle ausgebildet, die eine Elektrolytlösung, vorzugsweise die für das Galvanisieren verwendete Elektrolytlösung, enthält. Die Entmetallisierung erfolgt dann durch eine anodische Kontaktierung des Bürstenbandes relativ zu einer in der Reinigungs-Einrichtung RE befindlichen Kathode.

Fig. 2 zeigt mit der Kontaktiervorrichtung Kv2 eine weitere Möglichkeit für synchron mit den Leiterplatten Lp mitlaufende Kontaktmittel. Diese Kontaktmittel sind durch mehrere im Abstand zueinander an einem endlos umlaufenden Metallband Mb befestigte Kontaktfederpaare gebildet. Jedes Kontaktfederpaar besteht aus einer oberen Kontaktfeder Kfo und einer gegenüberliegenden unteren Kontaktfeder Kfu, welche die Seitenränder der Leiterplatten Lp unter Aufrechterhaltung eines gewissen federnden Kontaktdruckes zwischen sich aufnehmen. Die Stromzufuhr zu dem Metallband Mb erfolgt über eine rückseitig ortsfest angeordnete Stromschiene Ss und Bürsten Brs. Eine Zufuhr über Federn wäre selbstverständlich auch möglich. Die Stromschiene Ss ist vorzugsweise durch einen titanummantelten massiven Kupferleiter gebildet. Die Bürsten Brs bestehen vorzugsweise aus Kupfer, während sich für das Metallband Mb und die Kontaktfedern Kfo und Kfu Titan als Werkstoff sehr gut bewährt hat. Eine Reinigung bzw. Metallisierung der Kontaktfedern Kfo und Kfu ist auch hier nach dem in Fig. 1 dargestellten Prinzip möglich.

## Patentansprüche

1. Galvanisiereinrichtung für im horizontalen Durchlauf zu behandelnde plattenförmige Werkstücke, insbesondere Leiterplatten (Lp), mit
- einer Transporteinrichtung (Te) für den Transport der Werkstücke durch eine Elektrolytlösung,
- mindestens einer seitlich der Durchlaufbahn angeordneten Kontaktiervorrichtung (Kv1;Kv2) mit endlos umlaufenden Kontaktmitteln zur kathodischen Kontaktierung der Werkstücke,
- einer seitlich der Durchlaufbahn angeordneten Abdeckung zum Schutz der Kontaktmittel der Kontaktiervorrichtung (Kv1;Kv2) vor dem Zutritt von Elektrolytlösung und mit
- mindestens einer im Bereich der rücklaufenden Kontaktmittel angeordneten Reinigungs-Einrichtung (RE) zur Reinigung der umlaufenden Kontaktmittel,
**dadurch gekennzeichnet,**
daß zur Erfassung des über die Abdeckung überstehenden Seitenrandes der Werkstücke endlos umlaufende und mit dem Werkstück mitlaufende Kontaktbürsten (Kb) oder Kontaktfedern (Kfo,Kfu) als Kontaktmittel vorgesehen sind.

2. Galvanisiereinrichtung nach Anspruch 1,
**gekennzeichnet durch**
synchron mit dem Werkstück mitlaufende Kontaktbürsten (Kb) oder Kontaktfedern (Kfo,Kfu).

3. Galvanisiereinrichtung nach Anspruch 1 oder 2,
**gekennzeichnet durch**
Kontaktbürsten (Kb) in Form eines endlos umlaufenden Bürstenbandes welches im Kontaktierungsbereich auf einer rückseitig angeordneten Stromschiene (Ss) gleitet.

4. Galvanisiereinrichtung nach Anspruch 1 oder 2,
**dadurch gekennzeichnet,**
daß auf einem endlos umlaufenden Metallband (Mb) paarweise einander gegenüberliegende Kontaktfedern (Kfo,Kfu) befestigt sind, die federnd an der Oberseite und der Unterseite der Werkstücke anliegen.

5. Galvanisiereinrichtung nach einem der vorhergehenden Ansprüche,
**gekennzeichnet durch**
eine als elektrolytische Entmetallisierungszelle ausgebildete Reinigungs-Einrichtung (RE).

## Claims

1. Electroplating apparatus for plate-type workpieces, in particular printer circuit boards (Lp), to be treated while being conveyed horizontally, comprising
- a conveyance device (Te) for the conveyance of the workpieces through an electrolyte solution,
- at least one connection device (Kv1; Kv2) which is disposed at the side of the conveyance path and has endlessly circulating connection means for cathodically connecting the workpieces,
- a cover disposed at the side of the conveyance path for protecting the contact means of the connection device (Kv1; Kv2) against the access of electrolyte solution, and
- at least one cleaning device (RE), disposed in the vicinity of the returning contact means, for cleaning the circulating contact means,
characterised in that endlessly circulating contact brushes (Kb) or contact springs (Kfo, Kfu) which travel concomitantly with the workpiece are provided as contact means for engaging the side edge of the workpieces which extends beyond the cover.

2. Electroplating apparatus according to Claim 1, characterised by contact brushes (Kb) or contact springs (Kfo, Kfu) which travel synchronously and concomitantly with the workpiece.

3. Electroplating apparatus according to Claim 1 or 2, characterised by contact brushes (Kb) in the form of an endlessly circulating brush belt which slides in the connection region on a current bar (Ss) disposed at the rear.

4. Electroplating apparatus according to Claim 1 or 2, characterised in that contact springs (Kfo, Kfu) which are mutually opposite one another in pairs and which rest resiliently on the top and bottom of the workpieces are mounted on an endlessly circulating metal belt (Mb).

5. Electroplating apparatus according to one of the preceding claims, characterised by a cleaning device (RE) constructed as an electrolytic demetallisation cell.

## Revendications

1. Installation de galvanisation des pièces en forme de plaques, notamment des plaquettes de circuits imprimés (Lp), à traiter pendant leur déplacement horizontal, comportant
- un dispositif de transport (Te) pour le transport des pièces à travers une solution électrolytique,
- au moins un dispositif d'établissement de contacts (Kv1 ; Kv2) placé sur le côté de la voie de déplacement et comportant des moyens de contact tournant sans fin pour l'établissement de contacts cathodiques des pièces à traiter,
- un recouvrement disposé sur le côté de la voie de déplacement pour la protection des moyens de contact du dispositif d'établissement de contacts (Kv1 ; Kv2), avant l'alimentation en solution électrolytique, et
- au moins un dispositif de nettoyage (RE) placé dans la zone de retour des moyens de contact, pour le nettoyage des moyens de contact tournant,
caractérisée en ce que,
il est prévu, comme moyens de contact, pour saisir le bord latéral des pièces qui débordent le recouvrement, des brosses de contact (Kb) ou des ressorts de contact (Kfo, Kfu) en déplacement sans fin et accompagnant la pièce à traiter.

2. Installation de galvanisation selon la revendication 1,
caractérisée par,
des brosses de contact (Kb) ou des ressorts de contact (Kfo, Kfu) en déplacement synchrone avec la pièce à traiter.

3. Installation de galvanisation selon la revendication 1 ou 2,
caractérisée par,
des brosses de contact (Kb) sous la forme d'une bande de brosses en déplacement sans fin, qui glisse, dans la zone d'établissement de contact, sur une barre conductrice (Ss) placée côté arrière.

4. Installation de galvanisation selon la revendication 1 ou 2,
caractérisée en ce que,
sur une bande métallique (Mb) en déplacement sans fin, sont fixés des ressorts de contact (Kfo, Kfu) qui sont accouplés les uns en face des autres et qui portent élastiquement sur le côté supérieur et le côté inférieur des pièces à traiter.

5. Installation de galvanisation selon l'une des revendications précédentes,
caractérisée par,
un dispositif de nettoyage (RE) réalisé comme cellule de démétallisation électrolytique.
